# EUROPEAN PATENT APPLICATION

(11) **EP 2 495 772 A1**
(43) Date of publication of application: **05.09.2012**
(21) Application number: 11156568.5
(22) Date of filing: 02.03.2011
(51) Int. Cl.: H01L 33/00, H01L 33/20, H01L 33/50, H01L 33/38, H01L 33/46, H01L 33/58, H01L 33/40, H01L 33/32, H01L 33/12, H01L 27/15, H01L 33/08

(54) **Semiconductor light emitter device**

(71) Applicant: Azzurro Semiconductors AG, 39106 Magdeburg (DE)
(72) Inventor: Schweeger, Giogio, 39106 Magdeburg (DE); Sickmöller, Markus, 39106 Magdeburg (DE)
(74) Representative: Eisenführ, Speiser & Partner

(57) **Abstract**

A semiconductor light emitter device for emitting light having a photon energy, comprises
- a mechanical carrier made substantially of a material that is an absorbant of the light with the photon energy, and having a carrier bottom side and a carrier top side opposite to the carrier bottom side;
- a layer structure epitaxially deposited on the carrier bottom side of the mechanical carrier and comprising an active-layer stack with at least two semiconductor layers of opposite conductivity types, which is configured to emit light upon application of a voltage to the active-layer stack; and
- at least one opening in the mechanical carrier, the opening reaching from the carrier bottom side to the carrier top side and being arranged and shaped to allow a passage of light, which is emitted from the active-layer stack, through the opening in the mechanical carrier.

## Description

The present invention is in the field of semiconductor light emitter devices, and applicable for instance, but not exclusively, in III-nitride semiconductor light emitter devices.

The following description on background prior art refers to the exemplary field of III-nitride semiconductor light emitter devices.

III-nitride semiconductors are used in light emitter devices for light emission in the green to ultra violet (UV) spectral range. The light emission in this spectral range can be used to trigger light emission in additional spectral ranges by including a luminescent material in light emitting diodes (LEDs) that absorbs the UV emission and in response emits light at a lower energy, i.e., longer wavelength or wavelength interval in the visible spectral range. This way, highly efficient low-current light emitters were achieved that exhibit light emission over a broad spectral range, including the white LEDs.

Since single-crystalline III-nitride semiconductors are not readily available in large amounts and sizes, foreign substrates are used in the fabrication of III-nitride light emitters, transparent substrates such as sapphire and silicon carbide are usually employed in the industry. However, sapphire is known to have poor heat conductivity, which leads to reliability problems in light emitter devices due to a risk of overheating during operation. Silicon carbide, on the other hand, is expensive.

Silicon is a substrate material that is abundantly available and much less costly in comparison. In fact, after intensive research and development, silicon can now be successfully used as a substrate for the growth of high-quality III-nitride semiconductors in spite of a large lattice mismatch and a large difference in thermal expansion characteristics. These problems were solved by sophisticated growth and strain engineering techniques. A remaining disadvantage of silicon as a substrate material in comparison with sapphire or silicon carbide is that it exhibits a strong absorption of light in the visible and ultraviolet spectral ranges. To fabricate light emitting diodes using a silicon substrate, a rather complex and expensive process is required, in which the silicon substrate is completely removed and the III-nitride semiconductor layers comprising an active-layer stack for light emission are transferred to a mechanical carrier. This process is referred to as a flip-chip process because the grown layer structure is mounted upside down, i.e., with the layers grown last facing the mechanical carrier.

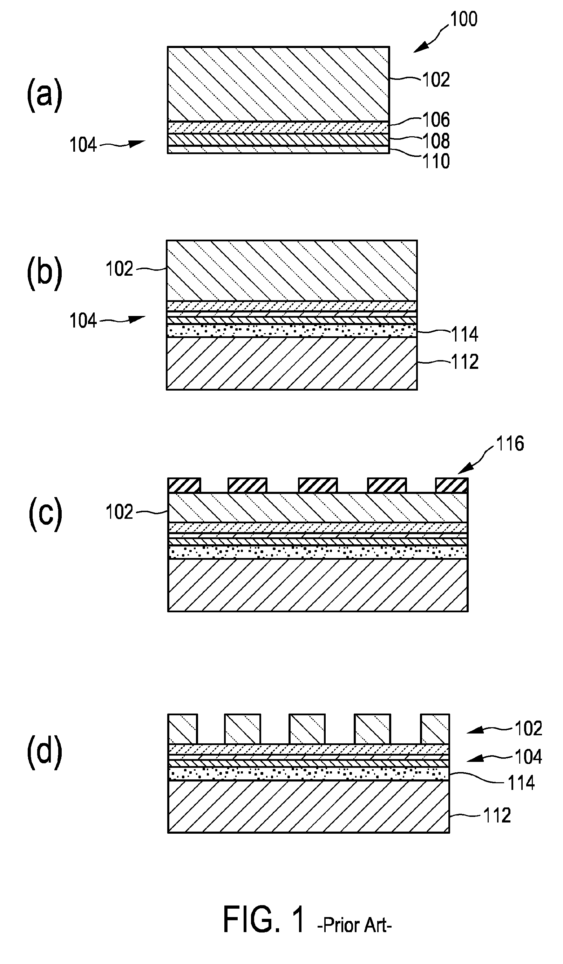

From the publication T. Egawa et al., J. Phys. D: Appl. Phys. 43, 2010, p. 354008, entitled "High performance InGaN LEDs on Si (111) substrates grown by MOCVD", a recent version of a flip-chip process for the fabrication of a III-nitride semiconductor LED is known. The process is described in the following with references to Figs. 1(a) to 1(d).

In a first process step, a silicon (111) substrate 102 is used to prepare a LED epiwafer structure 100 of Fig. 1(a). A LED layer structure 104 of the LED epiwafer 100 comprises buffer layers and active n- and p-doped III-nitride layers in a layer stack 106, a Ni contact layer 108 and an Al/Au reflector layer 110. Then, as shown in Fig. 1(b) the LED epiwafer 100 is bonded onto an Au plated copper carrier 112 using an indium adhesive layer 114. Subsequently the silicon substrate 102 is thinned down by mechanical polishing, and a polyimide mask 116 is deposited on the Si substrate 102, as shown in Fig. 1(c).

In a subsequent etching step the silicon substrate 102 is selectively removed in portions not covered by the polyimide mask 116, as shown in Fig. 1(d). In process steps not shown in Fig. 1, buffer layers comprised by the layer stack 106 are removed by reactive ion etching, and an exposed n-GaN layer is partially etched to expose a p-GaN layer comprised by the layer stack 106. Then, metal patterns are deposited on the exposed n-GaN as a transparent electrode.

The LED structure fabricated by the flip-chip process just described is intended to improve the optical output power in comparison with other LED structures known in the art.

However, it would be desirable to further enhance the optical output power of light emitters such as III-nitride semiconductor LEDs, which are fabricated on a substrate material that is not transparent to the emitted radiation, for instance because it has a band gap small enough to absorb the emitted radiation. It would further be desirable to provide a low-cost light-emitter with high output power, such as a III-nitride semiconductor LED, which can be fabricated without the requirement of transferring the device to a mechanical-carrier substrate.

According to the present invention, a semiconductor light emitter device for emitting light having a photon energy is provided, comprising:
- a mechanical carrier made substantially of a material that is an absorbant of the light with the photon energy, and having a carrier bottom side and a carrier top side opposite to the carrier bottom side;
- a layer structure epitaxially deposited on the carrier bottom side of the mechanical carrier and comprising an active-layer stack with at least two semiconductor layers of opposite conductivity types, which is configured to emit light upon application of a voltage to the active-layer stack; and
- at least one opening in the mechanical carrier, the opening reaching from the carrier bottom side to the carrier top side and being arranged and shaped to allow a passage of light, which is emitted from the active-layer stack, through the opening in the mechanical carrier.

The semiconductor light emitter device of the present invention has a mechanical carrier that is not transparent, for instance made substantially of a material that is an absorbant to the emitted light having the desired photon energy of the light emitter device. For light emitted in ultraviolet to visible spectral ranges, a prominent example of such a material is silicon. In contrast to known light emitter devices using an active-layer stack deposited on a such a substrate, the light emitter device of the present invention can be fabricated without employing a flip-chip process. In particular, the requirement of a separation of an active-layer stack from the substrate, on which it was originally grown, is overcome by the present invention. Therefore, in making the expensive flip-chip process obsolete for light emitter devices having an active-layer stack grown on non-transparent substrates such as silicon, the light emitter device of the present invention is a further breakthrough.

In contrast to the light emitter device disclosed by Egawa et al., the light emitter device of the present invention uses the substrate for epitaxial deposition also as a mechanical carrier. The problem of absorption of light emitted from the active-layer stack by the mechanical carrier is solved in the light emitter device of the present invention by providing the layer structure comprising the active-layer stack on the carrier bottom side and providing at least one opening in the carrier that allows the passage of light emitted from the active-layer stack.

The term "mechanical carrier" is used herein to point out the mechanical functions of the carrier, namely, to not only carry the active-layer stack, but in particular to provide mechanical protection and stability to the device to an extent that avoids breakage of the active-layer stack in the presence of mechanical forces applied to a light emitter device in an amount, which may typically occur during fabrication, handling, transport, installation and operation. As such, the mechanical carrier provides a stability which is required to keep the light emitter device essentially flat throughout the production process, therefore allowing that all the process steps can be performed on volume production tools. To fulfill these requirements of mechanical stability, a mechanical carrier must provide a suitable combination of mechanical material properties and material thickness. The term "mechanical carrier" is used herein without any implications on electrical properties.

However, the mechanical carrier may or may not be electrically conductive according to a particular application case. A good heat conductivity of the mechanical carrier is preferred to avoid damage to the device due to overheating during operation.

Without implying any restriction, but merely for enabling an intuitive understanding of the invention, the terms "top" and "bottom" are used in accordance with a non-restrictive example of a light emitter device oriented upright, i.e. emitting light mainly in a direction radially pointing away from the geocenter, through the openings in the carrier. The terms "carrier top side" and "carrier bottom side" only denote two opposite sides of the carrier, without implying any restriction regarding their actual orientation in the three-dimensional space. In other words, any of the two opposite main faces may actually be arranged facing the geocenter. However, the light emitter device of the present invention does require the light, which is emitted from the active-layer stack to pass through the opening in the mechanical carrier before entering an environment of the device.

In the following, embodiments of the light emitter device of the invention will be described. The additional features of the embodiments described herein can be combined with each other to form further embodiments, unless there are explicitly described as forming mutually exclusive alternatives to each other.

An important application case for the present invention are III-nitride semiconductor light emitters. III-nitride semiconductors are solid materials having as constituent elements N and one or more group-III metals such as Ga, Al, or ln. Group-V elements other than N may also be comprised in small fractions. III-nitride semiconductors, which herein are in short also referred to as III-nitride materials or III-nitrides, are fabricated for instance as binary, ternary or quaternary materials. Examples of binary materials are GaN, AIN and InN. Examples of ternary materials are AlGaN, InGaN and InAlN. A quaternary material is GaAllnN. A common way to refer to any member of this material family, be it binary, ternary or quaternary, is GaₓAl_{y}ln_{z}N, wherein 0≤x,y,z≤1 and x+y+z = 1, or in short GaAl-InN.

For the embodiment of a III-nitride-based light emitter that uses silicon as the mechanical carrier, the present invention provides that the advantage of silicon as an inexpensive substrate for III-nitride growth is no longer evened out by the disadvantage of an expensive fabrication process for a III-nitride-based light emitter device.

However, while the present specification mainly describes embodiments that use silicon as a mechanical carrier for III-nitride semiconductors, it should be noted that any semiconductor light emitter device having a mechanical carrier that is non-transparent for the light emitted from the device forms another suitable application case for the device structure of the present invention. The invention can also be applied to light emitter devices based on other active-layer materials and other substrate/mechanical-carrier materials. A non-transparent substrate is not restricted to the example of an absorbent material, i.e., a material that is to some degree absorbing the light emitted from the active-layer stack during operation of the light emitter device. Another example is a mechanical carrier that forms a scattering medium for light emitted from the active-layer stack and therefore reduces the optical output of the device.

As mentioned the carrier is made substantially of silicon in a preferred embodiment. Preferably, the carrier bottom side, on which the epitaxially deposited layer structure is arranged, has a carrier bottom surface of silicon or of a group-IV alloy comprising silicon and germanium. This surface is suited for the growth of III-nitride layers using known advanced epitaxial techniques for depositing the layer structure with the active-layer stack, based on gained experience in the art with the epitaxial deposition of III-nitrides on silicon. The results in this field of technology have improved considerably in recent years.

However, as an alternative it is also possible to employ a carrier, which is substantially made of silicon, but at the bottom carrier side provides a surface for epitaxial layer growth of a material different from silicon and even more suitable for an epitaxial deposition of III-nitrides. For major advantages of the invention are still achieved, namely the provision of a device structure that makes a flip-chip process obsolete in the industrial fabrication despite the use of a growth substrate as a carrier that is at least to some degree absorbing or even substantially opaque for the emitted radiation.

The light emitter device has in some embodiments a carrier top side with a surface of silicon or of a group-IV alloy comprising silicon and germanium. In these embodiments, an n-type contact layer structure is preferably arranged directly on this carrier top surface.

The contact can be improved by letting the n-type contact layer structure extend along a sidewall of the opening and at least partially cover an n-type III-nitride semiconductor layer of the active-layer stack at a bottom of the opening. In this embodiment, the n-type contact layer structure, in sections where it covers the n-type III-nitride semiconductor layer, is optically transparent for light emitted from the active-layer stack. Optically transparent contact layer materials for the spectral ranges in question are known in the art. For instance, the following materials can be used: Very thin layers of NiAu, Indium-tin-oxide (ITO) or transparent but conducting organic materials. On the sidewall of the opening the contact layer structure is preferentially made of a material that reflects light, so that light emitted into the opening is not absorbed by the carrier material but reflected into the environment.

In an alternative, currently not preferred embodiment, a p-type contact layer structure is deposited on the carrier top surface. This implies that p-type semiconductor layers are accessible for contacting through the opening. This can be achieved by performing the growth of the layer structure on the carrier bottom side such that p-type semiconducting layers are grown before n-type semiconductor layers. For III-nitride semiconductors, this order of growth is currently more difficult, but technically possible.

In the currently preferred embodiment, the p-type contact layer structure, on the other hand is preferably arranged adjacent to a p-type III-nitride semiconductor layer of the active-layer stack on the bottom side of the carrier. The p-type contact layer structure advantageously comprises a mirror layer, which is configured to reflect light of a wavelength emitted by the active-layer stack. This way, the output efficiency of the light emitter device can be further increased.

The active-layer stack on the bottom side of the carrier may be patterned by additional processing before the deposition of the p-type contact layer structure. For instance, the active-layer stack is in one embodiment limited in its lateral extension to approximately a lateral extension of the opening in the carrier, through which the light is emitted into the environment. This way, it is possible to let the mirror layer cover the active-layer stack also on a side wall of the active-layer stack.

The light emitter device may use an electrically conductive carrier. In alternative embodiments, the carrier is semi-insulating. A contact structure on the top side and reaching through the opening of a semi-insulating or even insulating carrier down to its bottom is sufficient to provide the required contacting.

In one embodiment, a lateral extension of the at least one opening decreases for at least one lateral direction, which is perpendicular to a depth direction pointing from top to the bottom carrier side, and for different positions along the depth direction between the top and bottom carrier sides. For instance, the opening may have the shape of an inverted cone. An increasing lateral extension of the opening as seen from the bottom towards the top carrier side improves the output of light in comparison with an opening that has vertical side walls, i. e., a constant lateral extension throughout the thickness of the carrier.

To further improve the efficiency of light emission and to focus the emitted light, the opening in the carrier maybe filled with a transparent lens. In addition or as an alternative, a filling maybe arranged in the opening and comprise a light-transforming material. Such light-transforming material is configured to absorb light of a first wavelength emitted by the active-layer stack and to emit light of a second wavelength or a whole range of wavelengths according to a desired spectral emission profile in response to the absorption of the light of the first wavelength, as is well known in the art and often referred to as luminescent or fluorescent material.

In preferred embodiments, the light emitter device comprises a plurality of openings in the carrier, each opening forming a part of an individual light emitter, wherein the individual light emitters have individual n-type and p-type contact structures configured to allow an individual control of an operation of each light emitter through the respective n-type and p-type contact structures. An individual control of an operation of each light emitter may also be achieved by configuring one type of contact structure as a common contact for all light emitters and the other as individual contact for each individual light emitter. Further embodiments of the light emitter device comprise a plurality of openings in the carrier, each opening forming a part of an individual light emitter, wherein the individual light emitters have n-type contact structure are interconnected and the p-type contact structures are interconnected, and thus are configured to allow a common control of an operation of the light emitters through the respectively interconnected n-type and p-type contact structures.

A driver circuit for driving the individual light emitters or a group of light emitters or the whole of light emitters may be provided directly on the carrier. This is a further advantage of using a carrier substantially made of silicon: electronic circuitry may be included with the optical light emitters on a single chip.

In the following, further embodiments of the light emitter device of the invention will be described with reference to the enclosed drawings. In the figures:
- Fig. 1 a) to d): show a fabrication method for a light emitting diode according to a prior-art flip-chip process.
- Fig. 2: shows an embodiment of a light emitting diode according to a first embodiment;
- Fig. 3: shows an embodiment of a light emitting diode according to a second embodiment;
- Fig. 4: shows an embodiment of a light emitting diode according to a third embodiment;
- Fig. 5: shows an embodiment of a light emitting diode according to a fourth embodiment;

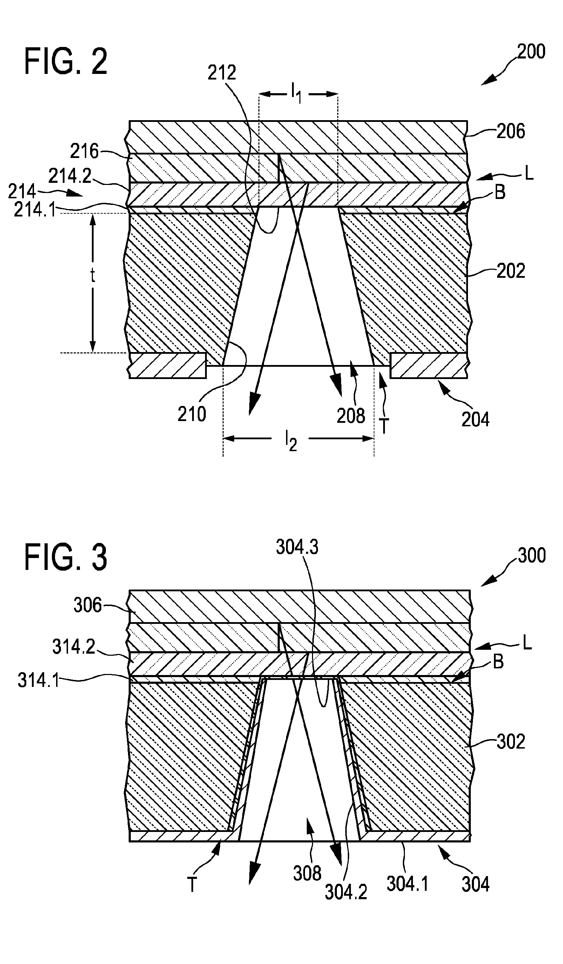

Fig. 2 shows a schematic cross-sectional view of a light emitter device formed by a light emitting diode (LED) 200 according to an embodiment of the present invention. Only a small lateral section of the device is shown.

The LED 200 has a mechanical carrier 202. The mechanical carrier 202 of the present embodiment is not transparent for light emitted from the LED. In the present embodiment, the carrier made 202 is a silicon wafer. A known type of silicon wafer may be used, which is typically employed for fabricating electronic devices in the semiconductor industry. However, the mechanical carrier 202 may also be formed from a special silicon wafer that for instance has a particular defined surface orientation, such as a Si(110), Si(211), Si(111), or a silicon surface that is textured by fabrication processes performed prior to the deposition of layer structures on the carrier, which will be described further below. A surface of the wafer may also be formed by a SiGe alloy epitaxially deposited before the fabrication of the actual LED 200 to enhance the nucleation and growth of a III-nitride layer structure L.

A typical thickness t of the silicon carrier is for instance 1000 µm. A minimum thickness is 300 µm. The thickness is chosen in dependence on the lateral extension of the carrier that is used, on the process parameters and stress level that is present at any time during the fabrication process of the device. The thickness is also chosen large enough to withstand mechanical stress during handling and transport of the carrier.

The mechanical carrier 202 has a bottom side B and a top side T. The use of the terms "bottom" and "top" corresponds to the typical orientation of the light emitting diode 200 during operation, and should not be interpreted in a manner restricting the orientation of the LED. Of course, the LED 200 may be mounted or oriented to point in any desired direction.

On the carrier top side T, an n-type contact 204 is deposited. On the opposite carrier bottom side B, a layer structure L is deposited, followed by a p-type contact structure 206.

Generally, the layer structure may be any III-nitride semiconductor layer structure that is suitable for operating the light emitter device 200 as a LED. There is abundant prior art that discloses many different types of suitable layer structures. For that reason only a coarse layer sequence is shown in Fig. 2. The detailed substructure of each of the layers shown may be chosen according to the requirements of a specific application. Accordingly, the layer structure L may be coarsely broken down in to an n-type III-nitride semiconductor layer 214 and a p-type III-nitride semiconductor layer 216. These will in the following be referred to in short as the n-type layer 214 and the p-type layer 216. The n-type layer 214 typically contains a nucleation and buffer-layer structure 214.1 and an active-layer stack 214.2. The active-layer stack 214.2 is deposited on the nucleation and buffer-layer structure 214.1 and extends up to a pn-junction in the range of the interface between the n-type layer 214 and the p-type layer 216.

The light emitter device 200 of Fig. 2 has an opening 208 in the silicon carrier 202. The opening 208 reaches from the carrier top side T to the carrier bottom side B and has inclined side walls resulting in a conical shape of the opening. Generally, opening shapes are preferred that have a smaller lateral extension L1 at the carrier bottom side B and a larger lateral extension L2 at the carrier top side T in order to reduce the shadowing effect of the sidewalls of the opening. Basically the same effect can for instance achieved by a step-shaped lateral profile with the mentioned lateral-extension properties.

In the present embodiment, the opening 208 continues into the n-type layer 214, approximately up to an interface between the nucleation and buffer-layer structure 214.1 and the active-layer stack 214.2. In another embodiment, the opening 208 only reaches to the interface between the mechanical carrier 202 and the n-type III-nitride semiconductor layer 214.

As noted before, LED 200 may comprise either one or a plurality of openings. The structure shown in Fig. 2 may be repeated in lateral directions, that is, in the paper plane of Fig. 2 on the left and/or right sides of the structure shown, and/or in directions perpendicular to the paper plane. Thus, either a single opening, a one-dimensional sequence or a two-dimensional matrix of openings may be provided in different variants of the LED 200. In order to achieve a high optical output density, it is preferred that the LED 200 contains a dense matrix of openings in the mechanical carrier 202, without, however, giving up its substantial contribution to the mechanical stability of the device.

Some remarks regarding advantageous processing techniques for the fabrication of the LED 200 are given in the following.

The nucleation and buffer-layer structure 214.1 is deposited by known epitaxial techniques directly on the carrier bottom side B of the mechanical carrier 202. A suitable process for depositing a nucleation and buffer-layer structure 214.1 and an active-layer stack 214.2 on silicon is for instance disclosed in US 2007/0197004A1, paragraphs [0019] to [0033] and [106] to [126]. The full disclosure of US 2007/0197004A1 is incorporated herein by reference.

The opening 208 can be fabricated by etching. In order to achieve a conical shape of the opening with a desired angle of inclination, a combination of anisotropic and isotropic etching techniques can be used. Examples of isotropic etching techniques are liquid etching or plasma etching. Anisotropic etching can for example be performed by reactive ion etching. It is possible to control the angle of inclination of the opening by adjusting a balance between the anisotropic and isotropic etching processes. Further influence can be taken by depositing a protective material on the side walls 210 of the opening 208 that are being revealed in the etching process. This way, an etching rate for already exposed side walls 210 is reduced, resulting in a steeper side wall closer to a 90° angle, while without using such side wall protection an inclination angle close to 45° is achieved. A suitable protective material used in this process is a polymer, for instance a polymer formed by the reaction of a photoresist with the etch gases during plasma etching, a process well known in the semiconductor industry for patterning processes. Another example for a suitable anisotropic etching method is electrochemically assisted wet etching.

A selective etching process is used to control the depth of the etched opening by automatically stopping on the interface of the silicon carrier with the III-nitride semiconductor layer 214.

If the etching continues into the layer structure L, a fixed-time etching process may be used, the time of etching being selected in accordance with the detailed sections of the layer structure to be etched.

It is noted that the contact layer structures 204 and 206 may be deposited over large areas of the device with a thickness that further increases mechanical stability. By making the contact layer structures 204 and 206 thicker, it becomes possible to increase the number and/or size of openings 208 in the mechanical carrier 202, without, however, giving up the substantial contribution of the mechanical carrier 202 to the mechanical stability of the LED 200.

In order to further enhance the output efficiency of the LED 200, the contact layer structure 206 can be made of a reflecting material such as a metal. For instance, using a layer structure of aluminum and chromium allows achieving a reflectivity of more than 90 % for the emitted light. The material of the contact layer structure should thus be chosen with a view to a high reflectivity in the desired spectral range of light emission.

In the following, some of the major advantages of the LED 200 will be explained.

In the LED 200 of Fig. 2, the silicon wafer that forms the mechanical carrier 202 has four functions: Firstly, it provides at least a substantial contribution to the mechanical stability of the LED 200, meaning that, if the mechanical carrier 202 was omitted, the LED 200 would not have a mechanical stability required for withstanding mechanical forces applied during manufacture and operation, and for instance caused by normal handling and thermal stress. Secondly, it serves as an electrically conductive layer that provides an electrical contact between the contact layer structure 204 and the n-type III-nitride layer 214 of the layer structure L. Thirdly, it serves as thermally conductive layer, thus being able to transport the heat away from the LED. And, last not least, it forms a substrate for the epitaxial growth of the layer structure L.

At least the last function clearly distinguishes the mechanical carrier 202 from the mechanical carrier used in the flip-chip process of Fig. 1, where the active-layer structure is first epitaxially deposited on a growth substrate, which is later removed in order to mount the active-layer structure onto a mechanical carrier different from the growth substrate. In comparison, the fabrication process for the LED 200 is much simpler and less costly. And in further comparison with the prior-art structure of Fig. 1, the silicon layer used there as a growth substrate for epitaxial deposition is later thinned down to a thickness that is not capable of providing substantial mechanical support and does require a foreign carrier substrate for the LED.

The conical shape of the opening has the advantage of providing a high output efficiency of the LED 200. For light generated in the active layer stack in operation (indicated by fat arrows in Fig. 2) is allowed to propagate through the openings in the carrier in a wider range of emission angles. The amount of absorption or scattering of emitted light by the side walls 210 of the opening 208 is reduced.

The LED 200 of Fig. 2 has the further advantage of achieving low electrical loss. As is known in the art, p-type III-nitrides have a relatively poor electrical conductivity, while n-type III-nitrides can be fabricated with a relatively high electrical conductivity. For this reason, the structure of the LED 200 minimizes the electrical loss by the arranging p-type contact structure 206 close to the p-type III-nitride layer 216. On the other hand, it uses the advantage of a relatively high conductivity of the n-type 111-nitride semiconductor layer 214 by bridging a larger distance between this layer and the pertaining n-type contact structure 204 with the silicon carrier 202, thus being able to achieve low electrical loses also on the n-type end of the LED. A further improvement in the electrical loss characteristics can be achieved by using large-area contact structures 204 and 206, as shown in Fig. 2.

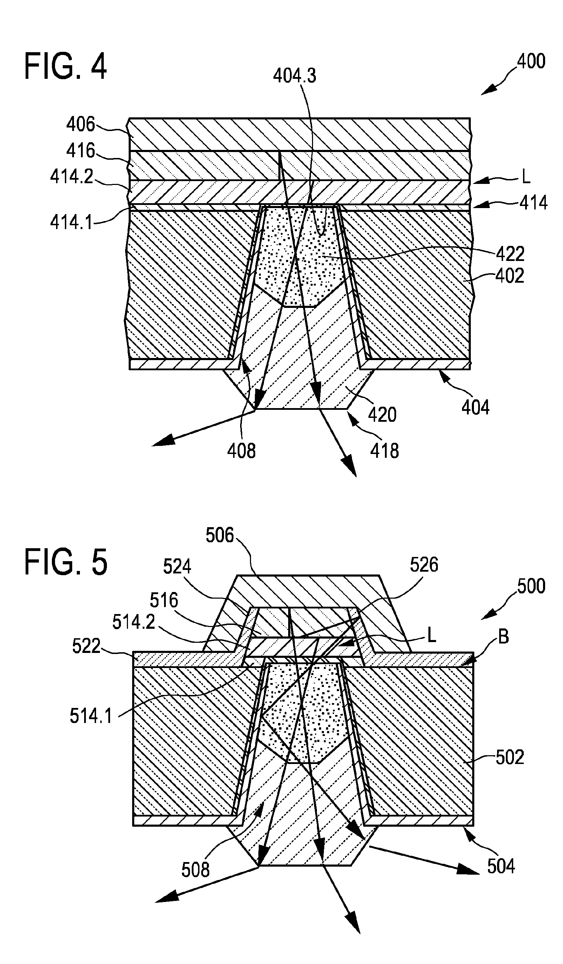

Fig. 3 shows a cross-sectional view of a second embodiment of a light emitting diode 300. The LED 300 closely resembles LED 200 of Fig. 2. For that reason, similar reference numerals are used in the following description for similar structural elements in comparison with the LED 200. The reference numerals differ only in the first digit, which in the present embodiment is a 3 instead of a 2, which was used for the embodiment of Fig. 2. The use of reference numerals in the subsequent Figs. 4 and 5 follows the same pattern.

While the embodiment of Fig. 3, in comparison with that of Fig. 2, also has an n-type contact structure 304 that is deposited on the top surface T of the silicon carrier 302 in a section 304.1, the n-type contact structure 304 of Fig. 3 additionally has a side-wall section 304.2, which is deposited on the side wall of the opening 308 and extends down to the n-type semiconductor layer 314. At the bottom of the opening 308 on the carrier bottom side B, the contact structure further extends over the n-type III-nitride layer 314. In this bottom section 304.3 of the n-type contact structure 304, it is formed by a transparent material layer. For the transparent section 304.3 of the contact layer structure 304, a indium-tin-oxide layer (ITO) may be used. However, other suitable transparent contact materials used in the art may be used as well. The sidewall section 304.2 contains a material which is suited to reflect light back into the opening and preventing it from penetrating into the carrier which is typically absorbing some or most of the light generated in the LED structure.

In comparison with the embodiment of Fig. 2, the n-type contact is further improved by this measure. For the rather poor electrical conductivities of the nucleation and buffer layers, which are arranged immediately adjacent to the bottom side of the mechanical carrier 302, are shunted by the side-wall and bottom sections 304.2 and 304.3 of the contact layer structure 304.

Accordingly, in order to enable this effect, the LED 300 has an opening 308 that extends into the n-type III-nitride layer 314 through the nucleation and buffer layer structure 314.1 to immediately contact high-quality sections of the n-type III-nitride semiconductor layer 314 in the active-layer stack 314.2.

A suitable processing for fabrication of this n-type layer structure contact may start with a two-step etching process in the fabrication of the opening 308. A first etching step stops when reaching the interface between the silicon carrier 302 and the III-nitride semiconductor layer 314. A second etching step, which may use a fixed time ascertained by experiment, as previously described, is used for removing the nucleation and buffer layer structure 314.1. This nucleation and buffer layer structure is typically made of AlN or AlGaN. Subsequently, the transparent section 304.3 of the n-type contact layer structure 304 may be deposited. This can be followed by depositing a metallic layer, which is then partly removed on top of the transparent contact layer section 304.3, in order to form the side-wall section 304.2 of the n-type contact layer structure 304. This side-wall section 304.2 should ideally be reflecting the light emitted from the active-layer stack. This can be achieved by using aluminium, chromium or silver.

In a variant of the above structure and process the transparent section 304.3 is omitted and only the side-wall sections 304.2 are fabricated to establish an electrical contact with the n-type III-nitride semiconductor layer 314 and a mirror to conduct the light out of the opening.

Fig. 4 shows an embodiment of a light emitting diode 400 according to a third embodiment. The embodiment of Fig. 4 is based on that of Fig. 3. In the following, again, only those features will be described, which distinguish the embodiment of Fig. 4 over that of Fig. 3.

The LED 400 of Fig. 4 has a filling 418 in the opening 408. In the most simple case, which is not shown in Fig. 4, the filling is a material that is highly optically transparent in the spectral range of the desired light emission from the LED 400 and that initially is plastically deformable to be filled into the opening 408 and suitably shaped to the form of a lens that redirects, focuses or spreads an emitted light bundle according to the desired output characteristics of the LED 400. An epoxy resin may for instance be used.

In a different embodiment, which is illustrated in Fig. 4, the filling 418 additionally comprises a phosphorescent component, which is shown in Fig. 4 as a sub-range 422 of the filling 418, which is arranged near the transparent bottom contact section 404.3 of the n-type contact structure 404. The phosphorescent component may for instance be of a type, which transforms emitted blue and/or ultraviolet light into yellow or red light, in order to achieve a mixture of emitted wave lengths, which has a desired spectrum or colour, for instance resulting in the emission of blue, green or white light.

With the embodiment of Fig. 4, large cost savings in the fabrication of the LED 400 can be achieved in comparison with prior-art fabrication techniques. In the prior art, III-nitride LED dies are mounted in special plastic mountings by gluing, contacted electrically, and then covered by the yellow and/or red phosphorescent component, and/or covered by the plastically deformable component. The embodiment of Fig. 4 does not require a gluing and electrical contacting of single diodes in a plastic mount. Rather, the opening 408 in the mechanical carrier 402 is used as a "mounting" for filling with the phosphorescent component and/or the lens material. This fabrication method is much less costly than that used in the prior art.

The embodiments of Fig. 2 to 4 are very well suited for fabrication of a large-area light emitter with a matrix comprising a large number of openings 408 in the mechanical carrier 402.

Fig. 5 shows an embodiment of a light emitting diode 500 according to a fourth embodiment. The embodiment of Fig. 5 is based on that of Figs. 2 to 4. The following description, again, focuses on differences.

In the embodiments of Figs. 2 to 4, and for example in Fig. 4, light emission also occurs in regions of the active-layer stack, which are not positioned within the interval of lateral extensions of the opening 408, but in lateral sections, which are outside the range of the opening 408 or between neighboring openings 408 in the mechanical carrier 402. Light emitted from these sections will be mostly absorbed by the material of the mechanical carrier 402. This tends to heat up the mechanical carrier. In order to improve the output efficiency, the LED 500 in the embodiment of Fig. 5 uses a III-nitride layer structure L, which is laterally patterned to extend only in the lateral range of the opening 508.

The p-type contact structure 506 also covers the side faces 525 and 526 of the III-nitride layer structure L. In the embodiment shown in Fig. 5 the p-contact structure 506 does not extend between individual openings 508, but only serves to contact the individual LED shown. In this embodiment, therefore, each individual diode can be contacted separately.

The layer structure L is patterned during fabrication by etching those regions, which are at a larger distance from the opening 508. The bottom side B of the mechanical carrier 502 is covered by an electrically isolating layer 522, which also extends on side walls 524 and 526 of the layer structure L. The electrically isolating layer 522 serves to avoid an electrical contact between the p-type contact structure 506 and the n-type side of the LED 514.2 or the mechanical carrier 502. Such an undesired electrical contact would lead to a short cut between the n-type contact structure 504 and the p-type contact structure 506.

It is noted that the structuring of the III-nitride layer structure L can be performed before etching the openings 508 in the mechanical carrier 502. This method requires that the fabrication of the openings involves a backside alignment. Such a backside alignment is not required in an alternative method, in which the etching of the III-nitride layer structure L is performed after etching the openings 508. However, this alternative method is more demanding with respect to the handling of the wafer, even though the alignment before the step of etching the layer structure L is easier to perform.

In a variant based on the embodiment of Fig. 5, the p-type contact structure 506 extends also between the individual openings to connect different light emitters.

As a further alternative, it is also possible to let the p-type contact structure 506 or the n-type contact structure 504 extend to cover a predetermined group of light emitters, while another group of light emitters on the same chip or die is not comprised by this group and is contacted individually or as a separate group.

## Claims

1. A semiconductor light emitter device, for emitting light, comprising
- a mechanical carrier that is not transparent for the emitted light, and having a carrier bottom side and a carrier top side opposite to the carrier bottom side;
- a layer structure epitaxially deposited on the carrier bottom side of the mechanical carrier and comprising an active-layer stack with at least two semiconductor layers of opposite conductivity types, which is configured to emit light upon application of a voltage to the active-layer stack; and
- at least one opening in the mechanical carrier, the opening reaching from the carrier bottom side to the carrier top side and being arranged and shaped to allow a passage of light, which is emitted from the active-layer stack, through the opening in the mechanical carrier.

2. The light emitter device of claim 1, wherein a lateral extension of the at least one opening decreases for at least one lateral direction, which is perpendicular to a depth direction pointing from top to the bottom carrier side, and for different positions along the depth direction between the top and bottom carrier sides.

3. The light emitter device of one of the preceding claims, comprising, on the carrier bottom side, a carrier bottom surface of silicon or of a group-IV alloy comprising silicon and germanium, wherein the semiconductor layers of the active-layer stack are III-nitride semiconductor layers.

4. The light emitter device of one of the preceding claims, having, on the carrier top side, a carrier top surface of silicon or of a group-IV alloy comprising silicon and germanium, wherein an n-type contact layer structure is arranged on the second carrier surface.

5. The light emitter device of claim 4, wherein the n-type contact layer structure extends along a sidewall of the opening and at least partially covers an n-type III-nitride semiconductor layer of the active-layer stack at a bottom of the opening, and wherein the n-type contact layer structure, in sections where it covers the n-type III-nitride semiconductor layer, is optically transparent for light emitted from the active-layer stack, and, in sections where it covers the sidewall of the opening, is reflective for emitted light that impinges on the sidewall from the opening.

6. The light emitter device of one of the preceding claims, wherein a p-type contact layer structure is arranged adjacent to a p-type III-nitride semiconductor layer of the active-layer stack on the bottom side of the carrier.

7. The light emitter device of claim 6, wherein the p-type contact layer structure comprises a mirror layer, which is configured to reflect light of a wavelength emitted by the active-layer stack.

8. The light emitter device of claim 6 or 7, wherein the active layer stack is limited in its lateral extension to approximately a lateral extension of the opening.

9. The light emitter device of claims 7 and 8, wherein mirror layer covers the active-layer stack also on a layer-stack sidewall.

10. The light emitter device of one of the preceding claims, wherein the carrier is electrically conductive.

11. The light emitter device of one of the preceding claims, wherein the carrier is semi insulating.

12. The light emitter device of one of the preceding claims, wherein the opening is filled with a transparent lens.

13. The light emitter device of one of the preceding claims, wherein a filling of the opening comprises a light-transforming material, which is configured to absorb light of a first wavelength emitted by the active-layer stack and to emit light of a second wavelength different from the first wavelength in response to the absorption of the light of the first wavelength.

14. The light emitter device of one of the preceding claims, comprising a plurality of openings in the carrier, each opening forming a part of an individual light emitter, wherein the individual light emitters have individual n-type and p-type contact structures configured to allow an individual control of an operation of each light emitter through the respective n-type and p-type contact structures.

15. The light emitter device of one of the preceding claims, comprising a plurality of openings in the carrier, each opening forming a part of an individual light emitter, wherein the individual light emitters have n-type and p-type contact structures, at least one of which are interconnected.
